# EUROPÄISCHE PATENTSCHRIFT

(11) **EP 3 208 841 B1**
(45) Veröffentlichungstag und Bekanntmachung des Hinweises auf die Patenterteilung: **09.12.2020**
(21) Anmeldenummer: 16156488.5
(22) Anmeldetag: 19.02.2016
(51) Int. Cl.: H01L 23/373, B23K 20/02, B32B 15/01, H01L 21/48

(54) **VERFAHREN ZUR HERSTELLUNG EINER WÄRMESPREIZPLATTE, WÄRMESPREIZPLATTE, VERFAHREN ZUR HERSTELLUNG EINES HALBLEITERMODULS UND HALBLEITERMODUL**
METHOD FOR PRODUCING A HEAT SPREADING PLATE, HEAT SPREADING PLATE, METHOD OF MANUFACTURING A SEMICONDUCTOR MODULE AND SEMICONDUCTOR MODULE
PROCEDE DE FABRICATION D'UNE PLAQUE DE DISSIPATION THERMIQUE, PLAQUE DE DISSIPATION THERMIQUE, PROCEDE DE FABRICATION D'UN MODULE A SEMI-CONDUCTEURS ET MODULE A SEMI-CONDUCTEURS

(43) Veröffentlichungstag der Anmeldung: 23.08.2017
(73) Patentinhaber: Heraeus Deutschland GmbH & Co. KG, 63450 Hanau (DE)
(72) Erfinder: Eisele, Ronald, 24229 Surendorf (DE)
(74) Vertreter: Meissner Bolte Partnerschaft mbB

(56) Entgegenhaltungen:
- EP-A1- 0 550 999
- EP-A1- 2 390 914
- EP-A1- 2 400 571
- JP-A- 2015 213 097
- US-A1- 2014 231 815
- CHRISTIAN MERTENS ED - MERTENS CHRISTIAN: "Die Niedertemperatur-Verbindungstechnik der Leistungselektronik", 1 January 2004 (2004-01-01), DIE NIEDERTEMPERATUR-VERBINDUNGSTECHNIK DER LEISTUNGSELEKTRONIK (BOOK SERIES: FORTSCHRITT-BERICHTE VDI); [FORTSCHRITT-BERICHTE VDI : REIHE 21, ELEKTROTECHNIK ; 365], VDI VERLAG, DÜSSELDORF, GERMANY, PAGE(S) 1 - 35,72, XP002541611, ISBN: 978-3-18-336521-0

## Beschreibung

Die Erfindung betrifft eine Wärmespreizplatte. Außerdem betrifft die Erfindung ein Verfahren zur Herstellung eines Halbleitermoduls sowie ein Halbleitermodul.

Leiterbahnen und Wärmespreizplatten in leistungselektronischen Aufbauten bestehen üblicherweise aus Kupfer. Kupfer weist gute Strom- und Wärmeleiteigenschaften auf. Zudem handelt es sich um ein äußerst günstiges Material. Silber weist noch bessere Strom- und Wärmeleiteigenschaften auf, ist jedoch um ein Vielfaches teurer als Kupfer. Um die erforderlichen Dicken für Leiterbahnen von beispielsweise 0,2 - 2,0 mm oder für Wärmespreizplatten von beispielsweise 1,5 - 5 mm zu erhalten, wäre Silber ein unakzeptabel teures Material. Leistungshalbleiter bestehen typischerweise aus Silizium, Siliziumkarbid oder Galliumnitrid. Materialien von Leistungshalbleitern sowie Materialien keramischer Schaltungsträger besitzen einen deutlich niedrigeren thermischen Ausdehnungskoeffizient als Kupfer. Kupfer weist einen Ausdehnungskoeffizient von 17,8 ppm/K auf, wohingegen typische Keramikschaltungsträger thermische Ausdehnungskoeffizienten von 2,5 - 7,1 ppm/K aufweisen.

Zur Reduzierung der thermischen Dehnung der Kupfer-Leiterbahnen und Kupfer-Wärmespreizplatten werden bereits Legierungen und Plattierungen des Kupfers mit dehnungsarmen Metallen eingesetzt. Es existieren beispielsweise Kupfer-Wolfram-Legierungen (CuW) und Kupfer-Molybdän-Legierungen (CuMo). Auch Cu-Mo-Cu-Plattierungen sind bekannt. Daraus resultieren thermische Dehnungen zwischen 8 ppm/K und 12 ppm/K.

CuW- und CuMo-Legierungen sowie Cu-Mo-Cu-Plattierungen sind technologisch aufwendig herzustellen und äußerst teuer. Insbesondere die Legierungsbildung erfordert aufgrund des hohen Schmelzpunktunterschiedes zwischen Kupfer und den Legierungsbestandteilen Wolfram (W) und Molybdän (Mo) äußerst umfangreiche Verfahrensschritte bis zur erfolgreichen Legierung. Außerdem wird die Wärmeleitfähigkeit des reinen Kupfers durch die Legierungsbildung stark reduziert. Dies stellt einen wesentlichen Nachteil der kostenintensiven Legierung dar.

Die Plattierung von Kupfer und Molybdän muss zur Förderung der bindungsbildenden Diffusion bei sehr hohen Temperaturen, beispielsweise 600 °C - 800 °C, durchgeführt werden. Während dieses Hochtemperaturprozesses muss durch kostenintensive Maßnahmen die zerstörerische Oxidation des Kupfer-Materials verhindert werden.

Ein weiterer Nachteil der diffusionsgeglühten Schichtenfolge ist die starke Verformung und Verspannung nach Abkühlen von der Diffusionstemperatur zur Raumtemperatur bzw. Betriebstemperatur der leistungselektronischen Baugruppe, die mit der Wärmespreizplatte verbunden ist. Um plane Wärmespreizplatten herzustellen, müssen diese in Walzenstöcken streckgewalzt werden. Hierdurch wird teilweise die Diffusionsschicht mechanisch zerstört. Eine asymmetrisch geschichtete Folge von Kupferlagen und Molybdänlagen ist aus diesem Grund durch Diffusionsglühen nicht realisierbar.

Aus JP 2015 213097 A ist ein Verfahren zur Herstellung einer Wärmespreizplatte bekannt, wobei die Wärmespreizplatte eine erste Schicht aus einem ersten Material, eine zweite Schicht aus eine zweiten Material und eine Verbindungsschicht, die zwischen der ersten und zweiten Schicht ausgebildet ist, aufweist. Diese drei Schichten werden bei Verbindungstemperaturen von mindestens 800 °C miteinander verbunden.

Ausgehend von diesem Stand der Technik ist es Aufgabe der vorliegenden Erfindung, eine Wärmespreizplatte anzugeben, die äußerst dehnungsarm und gleichzeitig kostengünstig ist. Des Weiteren soll es mit Hilfe der erfindungsgemäßen Wärmespreizplatte ermöglicht werden, eine geringe, jedoch steuerbare Gesamt-Verformung der Wärmespreizplatte zu erzielen.

Des Weiteren ist es eine Aufgabe der vorliegenden Erfindung, ein Verfahren zur Herstellung eines Halbleitermoduls anzugeben. Ferner ist es Aufgabe der vorliegenden Erfindung, ein weiterentwickeltes Halbleitermodul anzugeben, wobei das Halbleitermodul äußerst dehnungsarm ist und eine geringe aber steuerbare Gesamtverformung der Wärmespreizplatte zusammen mit einem verbundenen Schaltungsträger ermöglicht.

Erfindungsgemäß wird die Aufgabe mit Blick auf die Wärmespreizplatte für einen Schaltungsträger durch den Gegenstand des Anspruches 1, mit Blick auf das Verfahren zur Herstellung eines Halbleitermoduls, umfassend eine Wärmespreizplatte und mindestens einen Schaltungsträger durch den Gegenstand des Anspruches 9 und mit Blick auf das Halbleitermodul, umfassend eine Wärmespreizplatte und mindestens einen Schaltungsträger, durch den Gegenstand des Anspruches 12 gelöst.

Ein im Zusammenhang mit der erfindungsgemäßen Wärmespreizplatte mögliches Verfahren zur Herstellung dieser Wärmespreizplatte für einen Schaltungsträger geht davon aus, dass mindestens eine erste Schicht aus einem ersten Material mit einem ersten Ausdehnungskoeffizient und mindestens eine zweite Schicht aus einem zweiten, dehnungsarmen Material mit einem zweiten Ausdehnungskoeffizient, der kleiner als der erste Ausdehnungskoeffizient ist, bei einer Verbindungstemperatur von 150 °C - 300 °C miteinander verbunden werden. Besonders bevorzugt erfolgt das Verbinden der ersten Schicht aus einem ersten Material mit der zweiten Schicht aus einem zweiten Material durch ein Niedertemperatursinterverfahren.

Außerdem ist zwischen der ersten Schicht und der zweiten Schicht mindestens eine erste Verbindungsschicht aus einem Verbindungsmaterial ausgebildet.

Die Verbindungstemperatur entspricht im Wesentlichen der Montagetemperatur bei der Verbindung der hergestellten Wärmespreizplatte mit mindestens einem Schaltungsträger.

Die Verbindungstemperatur kann 200 °C - 280 °C, insbesondere 220 °C - 270 °C, insbesondere 240 °C - 260 °C, insbesondere 250 °C, betragen.

Das Verbindungsmaterial der Verbindungsschicht kann vorzugsweise eine Verbindung herstellen, die Temperaturen überhalb der Verbindungstemperatur standhält. Vorzugsweise weist das Verbindungsmaterial ein Diffusionsmetall, insbesondere Silber (Ag) und/oder eine Silberlegierung und/oder Gold (Au) und/oder eine Goldlegierung und/oder Kupfer (Cu) und/oder eine Kupferlegierung, auf.

Das erste Material mit dem ersten Ausdehnungskoeffizient der mindestens ersten Schicht weist vorzugsweise Kupfer und/oder eine Kupferlegierung auf.

Das zweite, dehnungsarme Material mit dem zweiten Ausdehnungskoeffizient der mindestens zweiten Schicht weist vorzugsweise eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), auf. Als besonders bevorzugtes Material hinsichtlich des zweiten Materials der mindestens zweiten Schicht hat sich Molybdän (Mo) bzw. eine Molybdänlegierung erwiesen.

Prinzipiell können als zweite Materialien alle Metalle verwendet werden, die einen geringeren Ausdehnungskoeffizient als das Metall des ersten Materials aufweisen. Sofern das erste Material Kupfer oder eine Kupferlegierung ist bzw. die erste Schicht aus Kupfer oder einer Kupferlegierung besteht, sind alle Metalle als zweites Material geeignet, die einen geringeren Ausdehnungskoeffizient als Kupfer aufweisen.

Je niedriger der Ausdehnungskoeffizient des zweiten Materials ist und je höher gleichzeitig die Wärmeleitfähigkeit des zweiten Materials ist, umso besser ist dieser Werkstoff als zweites Material geeignet. Die elektrische Leitfähigkeit ist physikalisch mit der thermischen Leitfähigkeit verbunden. Daher sind alle Metalle, die eine gute thermische und/oder elektrische Leitfähigkeit sowie eine niedrige thermische Dehnung besitzen, gut geeignet, um als zweites Material verwendet zu werden bzw. vom zweiten Material umfasst zu sein.

Folgende Tabelle zeigt in Spalte 6 den Ausdehnungskoeffizient des in der Spalte 1 aufgeführten Werkstoffes. Alle Werkstoffe, die demnach einen kleineren Ausdehnungskoeffizient als Kupfer aufweisen, sind folglich geeignet, als zweites Material zu dienen bzw. als zweites Material verwendet zu werden.

| | | | | | | | | |
|---|---|---|---|---|---|---|---|---|
| 1) Werkstoff (bzw. Kurzzeichen) | | | | 6) Ausdehnungskoeffizient linear (10^{+6∗}alfa) | | | | |
| 2) Dichte | | | | 7) Spez. Wärme | | | | |
| 3) Elastizitätsmodul | | | | 8) Elektrische Leitfähigkeit | | | | |
| 4) Schmelztemperatur | | | | 9) Temperaturkoeffizient des elektrischen Widerstands (10^{+3∗}alfa) | | | | |
| 5) Wärmeleitfähigkeit | | | | | | | | |

| 1) Werkstoff | 2) Dichte | 3) E. M | 4) Temp. | 5) WLF | 6) Ausd.k. | 7) sp. W. | 8) El.Leitf. | 9) Temp.K. |
|---|---|---|---|---|---|---|---|---|
| | kg/ dm³ | kp/ mm² | Grd Celsius | cal/ cmsecgrd | m/ mgrd | cal/ grgrd | m/ Ohmmm² | 1/ grd |
| Silber | 10,49 | 8160 | 960 | 1,00 | 19,7 | 0,056 | 63 | 4,10 |
| Kupfer | 8,96 | 12500 | 1083 | 0,94 | 16,2 | 0,092 | 60 | 4,31 |
| Eisen | 7,87 | 21550 | 1530 | 0,18 | 11,7 | 0,11 | 10,3 | 6,57 |
| Grauguß | 7,20 | 8000-13000 | 1150-1300 | 0,13 | 9,0 | 0,13 | 1-2 | |
| Molybdän | 10,2 | 33630 | 2625 | 0,35 | 5 | 0,061 | 19,4 | 4,73 |
| Monelmetall | 8,58 | 15900 | 1320-1350 | 0,06 | 14 | 0,12 | 1,6 | 0,19 |
| Nickel | 8,90 | 19700 | 1455 | 0,22 | 13,3 | 0,105 | 14,6 | 6,75 |
| Niob | 8,57 | 16000 | 2415 | | 7,0 | 0,0065 | 7,7 | |
| Osmium | 22,5 | 57000 | 2700 | | 4,6 | 0,031 | 10,4 | 4,45 |
| Platin | 21,45 | 17320 | 1774 | 0,17 | 8,9 | 0,032 | 10,2 | 3,92 |
| Stahl C 15 | 7,85 | 20800 | 1510 | 0,12 | 11,1 | 0,11 | 9,3 | 5,7 |
| Stahl C 35 | 7,84 | 20600 | 1490 | 0,12 | 11,1 | 0,11 | 8,6 | 5,2 |
| Stahl C 60 | 7,83 | 20400 | 1470 | 0,11 | 11,1 | 0,11 | 7,9 | 4,7 |
| 41Cr4 | 7,84 | 20700 | 1490 | 0,1 | 11,0 | 0,11 | 8,0 | |
| X10Cr13 | 7,75 | 22000 | 1500 | 0,065 | 10,0 | 0,11 | 1,7 | |
| 36% Ni-Stahl | 8,13 | 14500 | 1450 | 0,025 | 0,9 | 0,123 | | |
| Tantal | 16,6 | 18820 | 3000 | 0,13 | 6,6 | 0,036 | 8,1 | 3,47 |
| Titan | 4,54 | 10520 | 1800 | 0,041 | 10,8 | 0,126 | 1,25 | 5,46 |
| Vanadium | 6,0 | 15000 | 1735 | | 8,5 | 0,12 | 3,84 | |
| Wismut | 9,8 | 3480 | 271 | 0,020 | 12,4 | 0,034 | 0,94 | 4,45 |
| Wolfram | 19,3 | 41530 | 3380 | 0,48 | 4,5 | 0,032 | 18,2 | 4,82 |
| Zirkon | 6,5 | 6970 | 1850 | | 10 | 0,066 | 2,44 | 4,4 |

Das Verbinden der mindestens ersten Schicht mit der mindestens zweiten Schicht und der Verbindungsschicht kann mittels Druckbeaufschlagung, insbesondere mit einem Druck von 5 MPa - 30 MPa, insbesondere von 10 MPa - 28 MPa, insbesondere von 25 MPa erfolgen.

Eine vorzugsweise durchzuführende Niedertemperatursinterung zur Verbindung der mindestens ersten und mindestens zweiten Schicht und der mindestens einen Verbindungsschicht erfolgt vorzugsweise bei Temperaturen von 150 °C - 300 °C und bei einem beaufschlagten Druck von 5 MPa - 30 MPa. Besonders bevorzugt wird die Niedertemperatursinterung bei einer Temperatur von 250 °C und einem Druck von 25 MPa durchgeführt, wobei die Sinterung vorzugsweise 1 bis 10 min, beispielsweise 4 min, lang durchgeführt wird.

Die Verbindungstemperatur beim Verfahren zur Herstellung einer Wärmespreizplatte entspricht im Wesentlichen der Montagetemperatur bei der Verbindung der hergestellten Wärmespreizplatte mit mindestens einem Schaltungsträger. Die Verbindungstemperatur kann exakt der Montagetemperatur entsprechen. Des Weiteren ist es möglich, dass die Verbindungstemperatur höchstens 20 %, insbesondere höchstens 15%, insbesondere höchstens 10%, insbesondere höchstens 5%, von der Montagetemperatur abweicht. Die prozentuale Berechnung der Abweichung der Verbindungstemperatur von der Montagetemperatur erfolgt aufgrund einer Berechnung der Differenz zwischen der Verbindungstemperatur in Kelvin und der Montagetemperatur in Kelvin.

Neben dem Durchführen eines Niedertemperatursinterverfahrens ist es außerdem möglich, die einzelnen Schichten der Wärmespreizplatte durch Diffusionslöten mit der Ausbildung hochschmelzender intermetallischer Phasen miteinander zu verbinden. Auch die Verwendung von Klebstoffen zur Verbindung der einzelnen Schichten der Wärmespreizplatte ist möglich.

Vorzugsweise wird das Verbindungsmaterial als Sintermaterial bzw. Bestandteil des Sintermaterials zwischen die mindestens erste Schicht und die mindestens zweite Schicht eingebracht. Eine zu einer leitfähigen Schicht sinterfähige Zusammensetzung kann demnach zur Herstellung einer Sinterverbindung zwischen den zu verbindenden Schichten verwendet werden. Die noch sinterfähige Zusammensetzung kann die Anwendungsform einer Tinte, einer Paste oder einer Sintervorform in Form eines schichtförmigen Presslings besitzen. Sintervorformen bzw. sogenannte Sinter-Preforms entstehen durch Applikation und Trocknung von Metallpasten bzw. Metallsinterpasten. Derartige Sintervorformen sind noch sinterfähig. Alternativ ist es möglich, dass das Verbindungsmaterial als Folie, insbesondere als Metallfolie, ausgebildet ist und diese Folie, insbesondere Metallfolie, zwischen der ersten Schicht und der zweiten Schicht angeordnet wird.

Es ist möglich, dass die Sinterpaste, die das Verbindungsmaterial umfasst bzw. aus dem Verbindungsmaterial besteht, durch Drucken, insbesondere Sieb- oder Schablonendrucken, auf die erste Schicht und/oder die zweite Schicht aufgebracht wird. Optional kann die Sinterpaste bzw. Metallsinterpaste vor dem Durchführen des eigentlichen Sinterverfahrens getrocknet werden. Ohne den flüssigen Zustand zu durchlaufen, verbinden sich die Metallteilchen der Sinterpaste während des Sinterns durch Diffusion unter Ausbildung einer festen, elektrischen Strom- und Wärme-leitenden metallischen Verbindung bzw. Metallverbindung zwischen der mindestens ersten und zweiten Schicht. Besonders bevorzugt wird beim Verbinden der mindestens ersten und mindestens zweiten Schicht eine Sinterpaste verwendet, die Silber und/oder eine Silberlegierung und/oder Silberkarbonat und/oder Silberoxid umfasst.

Außerdem ist es möglich, dass auf die erste und/oder zweite Schicht, vorzugsweise auf die zweite Schicht, vor dem Aufbringen einer Verbindungsschicht eine, beispielsweise durch Galvanik oder Sputtern aufgebrachte, Schicht zur besseren Anbindung der Verbindungsschicht bzw. Fügeschicht aufgetragen wird. Sofern es sich bei der zweiten Schicht um eine Molybdän-Schicht handelt bzw. das zweite Material der zweiten Schicht Molybdän umfasst, kann auf die zu verbindende Seite der zweiten Schicht eine Nickel-Silber-Schicht (NiAg-Schicht) galvanisch aufgebracht werden. Auf dieser Nickel-Silber-Schicht kann das Verbindungsmaterial, insbesondere Silber, besonders gut haften.

Die Erfindung beruht auf dem Gedanken, eine Wärmespreizplatte für einen Schaltungsträger anzugeben, wobei die Wärmespreizplatte vorzugsweise mit einem vorerwähnten Verfahren hergestellt ist.

Die erfindungsgemäße Wärmespreizplatte umfasst:
- mindestens eine erste Schicht aus einem ersten Material mit einem ersten Ausdehnungskoeffizient, und
- mindestens eine zweite Schicht aus einem zweiten, dehnungsarmen Material mit einem zweiten Ausdehnungskoeffizient, der kleiner als der erste Ausdehnungskoeffizient ist,
- wobei zwischen der ersten Schicht und der zweiten Schicht mindestens eine erste Verbindungsschicht, die Diffusionsmetall, insbesondere Silber (Ag) und/oder eine Silberlegierung und/oder Gold (Au) und/oder eine Goldlegierung und/oder Kupfer (Cu) und/oder eine Kupferlegierung, umfasst, ausgebildet ist,
- eine asymmetrische Anordnung der ersten Schicht, der zweiten Schicht und der Verbindungsschicht, derart, dass eine konvex oder konkav geformte Wärmespreizplatte gebildet ist.

Das erste Material weist vorzugsweise Metall auf oder besteht aus Metall. Insbesondere weist das erste Material Kupfer auf oder das erste Material ist Kupfer oder eine Kupferlegierung. Das zweite Material kann eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), aufweisen. Vorzugsweise ist das zweite Material eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung).

In einer besonders bevorzugten Ausführungsform der Erfindung umfasst das zweite Material Molybdän (Mo). In einer besonders bevorzugten Ausführungsform der Erfindung ist das zweite Material Molybdän (Mo). Es ist auch denkbar, dass das zweite Material eine Molybdänlegierung umfasst oder eine Molybdänlegierung ist.

Die mindestens erste Verbindungsschicht kann als Grenzschicht der ersten Schicht und/oder der zweiten Schicht ausgebildet sein.

Es ist möglich, dass die Verbindungsschicht eine selbstständige sichtbare Schicht ist. Sofern das Verbindungsmaterial beim Herstellen der erfindungsgemäßen Wärmespreizplatte lediglich mit einer geringen Schichtdicke aufgetragen ist, kann die Verbindungsschicht im hergestellten Produkt, nämlich in der hergestellten Wärmespreizplatte, als Grenzschicht der ersten Schicht und/oder der zweiten Schicht ausgebildet sein. Das Verbindungsmaterial kann beispielsweise in die erste Schicht und/oder die zweite Schicht zumindest abschnittsweise eindiffundiert sein.

Besonders bevorzugt handelt es sich bei dem Verbindungsmaterial der Verbindungsschicht um Silber oder um eine Silberlegierung, so dass das Silber bzw. die Silberlegierung bei Ausbildung der Verbindungsschicht als Grenzschicht in die erste Schicht und/oder die zweite Schicht abschnittsweise eindiffundiert ist.

In einer weiteren Ausführungsform der Erfindung weist die Wärmespreizplatte mindestens eine dritte Schicht auf, wobei die dritte Schicht aus einem/dem ersten Material besteht. Die dritte Schicht ist vorzugsweise mittels einer zweiten Verbindungsschicht aus einem/dem Verbindungsmaterial mit der zweiten Schicht aus dem zweiten, dehnungsarmen Material verbunden. Die Wärmespreizplatte kann demnach drei Schichten umfassen, die mit Hilfe von zwei Verbindungsschichten miteinander verbunden sind.

In einer weiteren Ausführungsform der Erfindung kann die Wärmespreizplatte mindestens eine vierte Schicht aufweisen, die aus einem/dem zweiten Material gebildet ist. Die vierte Schicht ist vorzugsweise mittels einer dritten Verbindungsschicht aus einem/dem Verbindungsmaterial mit der dritten Schicht aus dem ersten Material verbunden. In dieser Ausführungsform der Erfindung umfasst die Wärmespreizplatte vier Schichten, die entweder aus dem ersten Material oder aus dem zweiten Material gebildet sind, wobei diese vier Schichten durch mindestens drei Verbindungsschichten miteinander verbunden sind.

Erfindungsgemäß sind die einzelnen Schichten und Verbindungsschicht(en) asymmetrisch angeordnet. Die einzelnen Schichten und Verbindungsschicht(en) sind insbesondere derart asymmetrisch angeordnet, dass eine konvex oder konkav geformte Wärmespreizplatte gebildet ist. Eine konvex oder konkav geformte Wärmespreizplatte kann auch als Wärmespreizplatte mit Balligkeit bzw. mit einer balligen Seite bezeichnet werden. Vorzugsweise weist die Wärmespreizplatte eine gesteuerte konvexe oder konkave Form auf. Mit anderen Worten ist das Balligkeits-Maximum definiert.

Eine asymmetrische Anordnung ist durch eine theoretisch gebildete Symmetrieachse sichtbar. Die Symmetrieachse halbiert die Gesamtdicke der Anordnung der einzelnen Schichten der Wärmespreizplatte, wobei die Gesamtdicke durch die Addierung der einzelnen Schichtdicken definiert ist. Vorzugsweise wird die Balligkeit bzw. die konvexe oder konkave Form der Wärmespreizplatte durch Anordnung und/oder Ausbildung der zweiten Schicht und/oder der vierten Schicht aus dem zweiten Material, nämlich dem dehnungsarmen Material gesteuert. Vorzugsweise wird bzw. werden die zweite Schicht und/oder die mindestens vierte Schicht in Relation zur Gesamtanordnung aller Schichten und Verbindungsschicht(en) asymmetrisch ausgebildet, so dass sich gezielt eine Symmetrieachse aus der Dehnung der hergestellten Wärmespreizplatte ergibt.

In Abhängigkeit des Anwendungsfalles kann durch die Position und/oder Ausbildung der zweiten Schicht und/oder der mindestens vierten Schicht aus einem dehnungsarmen zweiten Material nach finaler Abkühlung eine ballige Wärmespreizplattenkontur erzielt werden. Hierzu wird die erfindungsgemäße Wärmespreizplatte mit Hilfe des vorerwähnten erfindungsgemäßen Verfahrens hergestellt und mit dem noch nacherwähnten erfindungsgemäßen Verfahren zur Herstellung eines Halbleitermoduls mit einem Schaltungsträger verbunden.

In einer weiteren Ausführungsform der Erfindung kann bzw. können die zweite Schicht und/oder die vierte Schicht in einer Schicht aus dem ersten Material eingebettet sein. Bei der Schicht aus dem ersten Material kann es sich um die erste Schicht und/oder die dritte Schicht handeln.

In einer weiteren Ausführungsform der Erfindung ist bzw. sind die zweite Schicht und/oder die vierte Schicht rahmenartig und/oder gitterartig und/oder drahtartig ausgebildet. Vorzugsweise erfolgt diese Ausbildung der zweiten Schicht und/oder der vierten Schicht in Kombination mit dem Einbetten der jeweiligen Schicht in eine Schicht aus dem ersten Material.

Die Erfindung beruht des Weiteren auf dem Gedanken, ein Verfahren zur Herstellung eines Halbleitermoduls, das eine Wärmespreizplatte und mindestens einen Schaltungsträger, der mindestens einen Halbleiterbaustein trägt, umfasst, anzugeben. Vorzugsweise handelt es sich bei der Wärmespreizplatte um eine vorerwähnte erfindungsgemäße Wärmespreizplatte

Das erfindungsgemäße Verfahren zur Herstellung eines Halbleitermoduls beruht darauf, dass der Schaltungsträger mittels einer Kontaktierungsschicht mit der Wärmespreizplatte bei einer Montagetemperatur von 150 °C - 300 °C verbunden wird, wobei die Montagetemperatur im Wesentlichen der Verbindungstemperatur bei der Verbindung von/der Schichten der Wärmespreizplatte entspricht. Mit anderen Worten entspricht die Montagetemperatur bei der Verbindung des Schaltungsträgers mit der Wärmespreizplatte im Wesentlichen der Verbindungstemperatur, die bei der Herstellung der Wärmespreizplatte wirkt.

Die Montagetemperatur kann exakt der Verbindungstemperatur entsprechen. Vorzugsweise weicht die Montagetemperatur höchstens 20%, insbesondere höchstens 15%, insbesondere höchstens 10%, insbesondere höchstens 5%, von der Verbindungstemperatur ab. Die prozentuale Berechnung der Abweichung der Montagetemperatur von der Verbindungstemperatur erfolgt aufgrund einer Berechnung der Differenz zwischen der Montagetemperatur in Kelvin und der Verbindungstemperatur in Kelvin.

Die Montagetemperatur kann 200 °C - 280 °C, insbesondere 220 °C - 270 °C, insbesondere 240 °C - 260 °C, insbesondere 250 °C, betragen.

Der Schaltungsträger wird vorzugsweise auf die Oberfläche der Wärmespreizplatte aufgebracht bzw. mit der Oberfläche der Wärmespreizplatte verbunden, wobei die Oberfläche von einer Schicht, insbesondere der ersten Schicht oder der dritten Schicht, die aus einem ersten Material besteht, gebildet ist. Die Oberfläche kann auch als oberste Seite der Wärmespreizplatte bezeichnet werden.

Bei der Kontaktierungsschicht kann es sich beispielsweise um eine Sinterpaste handeln. Es ist auch möglich, dass es sich bei der Kontaktierungsschicht um eine Klebeschicht oder um eine Lotschicht handelt.

In einer Ausführungsform der Erfindung können die Verbindung der Schichten der Wärmespreizplatte und die Verbindung des Schaltungsträgers mit der Wärmespreizplatte gleichzeitig erfolgen. In dieser Ausführungsform werden alle Schichten, Verbindungsschicht(en) sowie der zu verbindende Schaltungsträger übereinander angeordnet und beispielsweise mittels eines Niedertemperatursinterverfahrens zur gleichen Zeit miteinander verbunden.

Durch Kombination der erfindungsgemäßen Wärmespreizplatte mit dem erfindungsgemäßen Verfahren zur Herstellung eines Halbleitermoduls, ist es möglich, eine Wärmespreizplatte mit asymmetrischer Anordnung der Schichten und Verbindungsschicht(en) derart herzustellen, dass eine definierte konvexe oder konkave Verformung der Wärmespreizplatte, mit anderen Worten ein definiertes Balligkeits-Maximum, erzeugt wird. Die einzelnen Schichten und Verbindungsschicht(en) werden asymmetrisch zueinander angeordnet. Die Asymmetrie kann durch die Anzahl der Schichten und/oder durch die Schichtdicken gesteuert werden.

Die asymmetrische Anordnung von Schichten und Verbindungsschicht(en) wird bei einer Verbindungstemperatur miteinander verbunden, die im Wesentlichen der Montagetemperatur der Wärmespreizplatte mit dem Schaltungsträger entspricht.

Es folgt die Verbindung der Substratplatte mit der Wärmespreizplatte. Hierbei zeigt sich, dass sich die konkave oder konvexe Verformung bei Wiedererwärmung der hergestellten asymmetrischen Wärmespreizplatte zurückbildet und nach der Verbindung der Wärmespreizplatte mit der Substratplatte in einem neuen Spannungsgleichgewicht in anforderungsgerechter Weise eine temperaturstabile Endgestalt einnimmt. Bei der temperaturstabilen Endgestalt kann es sich um ein definiertes Balligkeits-Maximum handeln. Beispielsweise beträgt ein definiertes Balligkeits-Maximum 100 µm.

Die Erfindung beruht des Weiteren auf dem Gedanken, ein Halbleitermodul anzugeben, wobei das Halbleitermodul vorzugsweise mit einem vorerwähnten erfindungsgemäßen Verfahren hergestellt ist. Das Halbleitermodul umfasst eine Wärmespreizplatte und mindestens einen Schaltungsträger, der mindestens einen Halbleiterbaustein trägt. Bei der Wärmespreizplatte handelt es sich vorzugsweise um eine erfindungsgemäße Wärmespreizplatte oder um eine Wärmespreizplatte, die mittels eines vorerwähnten erfindungsgemäßen Verfahrens hergestellt ist.

Der Schaltungsträger ist vorzugsweise als DCB (Direct Copper Bonding)-Substrat ausgebildet. Insbesondere ist der Schaltungsträger als Substratplatte aus Aluminiumoxid (Al₂O₃) und/oder Aluminiumnitrid (AIN) und/oder Siliziumnitrid (Si₃N₄) und/oder Zirkoniumoxid verstärktes Aluminiumoxid (ZTA zirconia toughened alumina), ausgebildet. Derartige Schaltungsträger weisen vergleichsweise geringe Ausdehnungskoeffizienten auf.

In einer weiteren Ausführungsform der Erfindung kann die Wärmespreizplatte des Halbleitermoduls mit einem Kühler verbunden sein, wobei vorzugsweise zwischen der Wärmespreizplatte und dem Kühler eine Wärmeleitpaste ausgebildet ist. Eine Montage der Wärmespreizplatte auf einem Kühler gestattet eine intensive und notwendige Kühlung der Verlustleistung des Halbleitermoduls über die Wärmespreizplatte zum Kühler an die Umgebung. Es ist dabei wichtig, dass die Wärmespreizplatte möglichst ohne Luftspalte oder Lufteinschlüsse formschlüssig auf der Oberfläche, insbesondere einer Montageplatte, des Kühlers aufliegt. Vorzugsweise wird demnach zwischen der Wärmespreizplatte und der Oberfläche des Kühlers bzw. der Montageplatte des Kühlers eine Wärmeleitpaste, insbesondere eine plastische Wärmeleitpaste, ausgebildet. Diese wird möglichst dünn und frei von Lufteinschlüssen zwischen der Wärmespreizplatte und der Oberfläche bzw. Montageplatte des Kühlers appliziert.

Vorzugsweise weist die Wärmespreizplatte lediglich eine geringe Balligkeit auf. Mit Hilfe der erfindungsgemäßen Wärmespreizplatte bzw. mit Hilfe des vorerwähnten erfindungsgemäßen Verfahrens kann eine Wärmespreizplatte mit geringer bzw. genau definierter Balligkeit erzeugt werden.

Die Wärmespreizplatte ist vorzugsweise mit der balligen Seite auf der Montageplatte bzw. Oberfläche des Kühlers montiert. Die Wärmespreizplatte kann mit dem darauf befindlichen Schaltungsträger beispielsweise mittels Schrauben auf den Kühler aufgepresst bzw. angepresst werden. Vorzugsweise wird die Pressung mit langsam steigender Spannung und ausgewählten Druckpositionen ausgeführt. Die konkave oder konvexe, mit anderen Worten ballige, Formgebung der Wärmespreizplatte bewirkt zunächst einen höchsten Anpressdruck auf die Mitte des Kühlers, wobei mit steigendem Montagedruck die Wärmeleitpaste langsam von innen nach außen gedrückt wird. Vorzugsweise wird dadurch ein Spalt zwischen der Wärmespreizplatte und der Oberfläche des Kühlers bzw. der Montageplatte des Kühlers mit der Wärmeleitpaste gefüllt. Überschüssige Wärmeleitpaste kann mit Hilfe dieses Montageverfahrens herausgepresst werden. Eine schädliche Anhäufung von Wärmeleitpaste zwischen der Wärmespreizplatte und der Oberfläche des Kühlers bzw. der Montageplatte des Kühlers wird somit vermieden.

Auf diese Art und Weise wird eine thermisch vorteilhafte Formschlüssigkeit und zugleich eine lösbare Verbindung zwischen der Wärmespreizplatte und dem Kühler zur Verfügung gestellt.

Die Erfindung wird nachfolgend mit weiteren Einzelheiten unter Bezugnahme auf die beigefügten schematischen Zeichnungen anhand von Ausführungsbeispielen näher erläutert. In diesen zeigen:
- Fig. 1a: die Anordnung einzelner Schichten einer Wärmespreizplatte;
- Fig. 1b: Wärmespreizplatte gemäß Fig. 1a im verbundenen Zustand;
- Fig. 2a: Anordnung einzelner Schichten einer erfindungsgemäßen Wärmespreizplatte;
- Fig. 2b: Anordnung einzelner Schichten einer Wärmespreizplatte gemäß einem nicht erfindungsgemäßem Ausführungsbeispiel;
- Fig. 3a und 3b: weitere Ausführungsformen hinsichtlich erfindungsgemäßer Wärmespreizplatten;
- Fig. 4a und 4b: Anordnung einzelner Schichten einer erfindungsgemäßen Wärmespreizplatte mit Schaltungsträger gemäß einer ersten Ausführungsform im unverbundenen und verbundenen Zustand
- Fig. 5a und 5b: Anordnung einzelner Schichten einer erfindungsgemäßen Wärmespreizplatte mit Schaltungsträger gemäß einer weiteren Ausführungsform im unverbundenen und verbundenen Zustand;
- Fig. 6: Anordnung einzelner Schichten einer erfindungsgemäßen Wärmespreizplatte mit Schaltungsträger gemäß einer weiteren Ausführungsform;
- Fig. 7a und 7b: Anordnung einzelner Schichten einer erfindungsgemäßen Wärmespreizplatte mit Schaltungsträger gemäß einer weiteren Ausführungsform im unverbundenen und verbundenen Zustand;
- Fig. 8a - 8c: konvexe Ausbildung von Wärmespreizplatten und darauf angeordneten Schaltungsträgern in verschiedenen Ausführungsformen; und
- Fig. 9: ein mit einem Kühler verbundenes Halbleitermodul.

Im Folgenden werden für gleiche und gleichwirkende Teile gleiche Bezugsziffern verwendet.

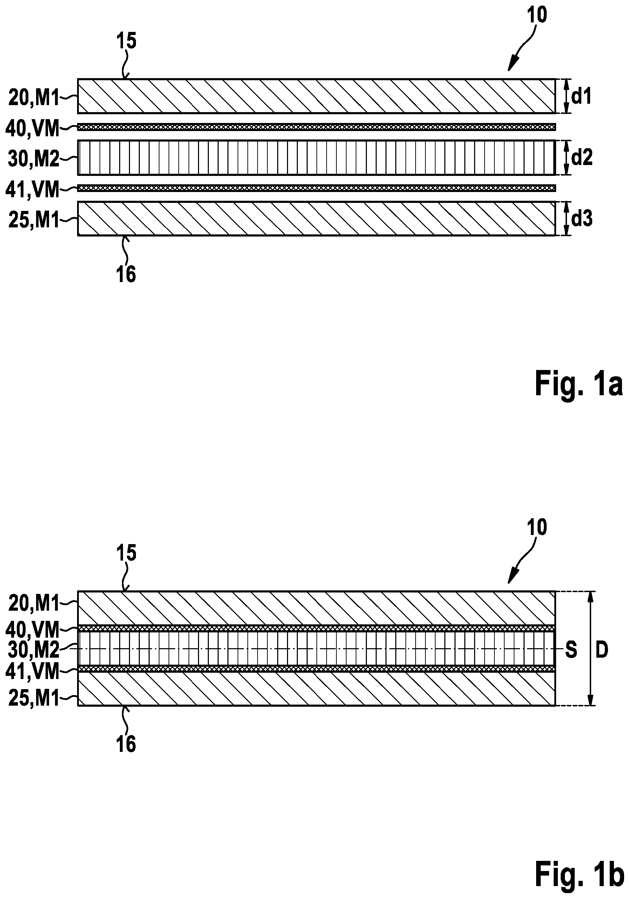

In Fig. 1a sind die einzelnen Schichten einer herzustellenden Wärmespreizplatte 10 (siehe Fig. 1b) dargestellt. Demnach umfasst die herzustellende Wärmespreizplatte 10 eine erste Schicht 20 aus einem ersten Material M1, eine zweite Schicht 30 aus einem zweiten Material M2 sowie eine dritte Schicht 25, die ebenfalls aus dem ersten Material M1 gebildet ist. Bei dem Material M1 handelt es sich vorzugsweise um Metall, insbesondere um Kupfer oder eine Kupferlegierung. Das Material M2 ist hingegen ein dehnungsarmes Material mit einem zweiten Ausdehnungskoeffizient, der kleiner ist als der erste Ausdehnungskoeffizient des ersten Materials M1. Bei dem zweiten Material M2 kann es sich um eine Nickellegierung, insbesondere Invar oder Invar 36 oder Kovar und/oder Wolfram und/oder eine Eisen-Nickel-Kobalt-Legierung handeln. Im vorliegenden Ausführungsbeispiel handelt es sich bei dem Material M2 um Molybdän.

Zwischen der ersten Schicht 20 und der zweiten Schicht 30 ist eine erste Verbindungsschicht 40 aus einem Verbindungsmaterial VM ausgebildet. Zwischen der zweiten Schicht 30 und der dritten Schicht 25 ist eine zweite Verbindungsschicht 41 aus dem Verbindungsmaterial VM ausgebildet. Das Verbindungsmaterial VM der Verbindungsschichten 40 und 41 schafft eine Verbindung zwischen den Schichten 20, 25 und 30, die Temperaturen oberhalb einer Verbindungstemperatur standhält. Vorzugsweise weist die Verbindungsschicht Diffusionsmetall, insbesondere Silber und/oder eine Silberlegierung und/oder Gold und/oder eine Goldlegierung und/oder Kupfer und/oder eine Kupferlegierung, auf.

Vorzugsweise ist die Verbindungsschicht als Sinterschicht, insbesondere als Sinterpaste ausgebildet. Diese Sinterpaste, die vorzugsweise eines der aufgeführten Diffusionsmetalle aufweist, kann beispielsweise mittels eines Druckverfahrens aufgebracht werden.

Vorzugsweise werden die Schichten 20, 25 und 30 bei einer Verbindungstemperatur von 150 °C - 300 °C durch ein Niedertemperatursinterverfahren miteinander verbunden. Besonders bevorzugt beträgt die Verbindungstemperatur 250 °C. Die Verbindungstemperatur zur Verbindung der Schichten 20, 25 und 30 mit Hilfe der Verbindungsschichten 40 und 41 entspricht im Wesentlichen der Montagetemperatur bei der Verbindung der hergestellten Wärmespreizplatte 10 mit einem aufzubringenden Schaltungsträger.

In Fig. 1b ist die hergestellte Wärmespreizplatte 10 zu erkennen. In dieser sind die Verbindungsschichten 40 und 41 zu erkennen. Es ist möglich, dass die Verbindungsschichten 40 und 41 als Grenzschichten der ersten Schicht 20, der dritten Schicht 25 sowie der zweiten Schicht 30 ausgebildet sind.

Das Verbinden der ersten Schicht 20 mit der zweiten Schicht 30 sowie mit der dritten Schicht 25 erfolgt vorzugsweise mittels Druckbeaufschlagung, insbesondere mit einem Druck von 5 MPa - 30 MPa, insbesondere von 10 MPa - 28 MPa, insbesondere von 25 MPa.

Wie in den Fig. 1a und 1b zu erkennen ist, sind die Schichtdicken d1 der ersten Schicht 20, d2 der zweiten Schicht 30 sowie d3 der dritten Schicht 25 gleich. Mit Hilfe der in Fig. 1b eingezeichneten Symmetrieachse S wird ersichtlich, dass es sich bei dem Aufbau der Wärmespreizplatte 10 um einen symmetrischen Aufbau der einzelnen Schichten 20, 25 und 30 sowie der Verbindungsschichten 40 und 41 handelt. Die Symmetrieachse S halbiert die Gesamtdicke D der Wärmespreizplatte 10. Die Gesamtdicke D wird durch Addition der Schichtdicken d1, d2 und d3 gebildet. Oberhalb und unterhalb der Symmetrieachse S zeigt sich ein symmetrischer Aufbau der Wärmespreizplatte 10. Mit Hilfe einer derartigen Wärmespreizplatte ist ein planer Aufbau bzw. eine plane Formgebung der Wärmespreizplatte 10 möglich.

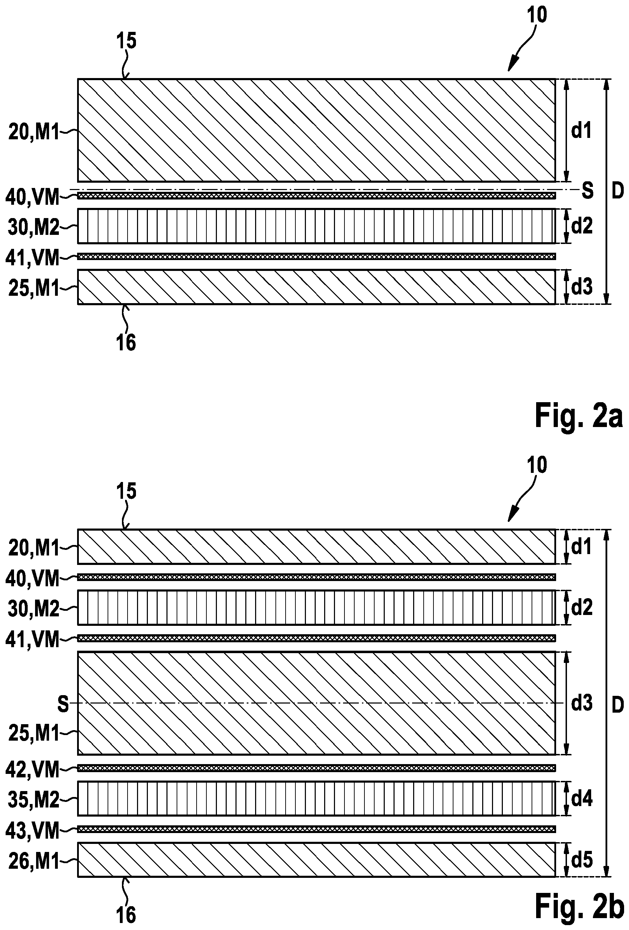

Fig. 2a zeigt hingegen eine erfindungsgemäße asymmetrische Anordnung der einzelnen Schichten 20, 25 und 30 und Verbindungsschichten 40 und 41. Bezüglich der Materialien und Verbindungsmöglichkeiten der einzelnen Schichten 20, 25 und 30 wird auf die vorherigen Erläuterungen im Zusammenhang mit Fig. 1a und Fig. 1b verwiesen.

Es zeigt sich, dass die Schichtdicke d1 der ersten Schicht 20 größer als die Schichtdicke d2 der zweiten Schicht 30 sowie der Schichtdicke d3 der dritten Schicht 25 ist. Eine angedeutete Symmetrieachse S, die die Gesamtdicke D der Wärmespreizplatte 10 halbiert, zeigt, dass die zu bildende Wärmespreizplatte 10 oberhalb und unterhalb der Symmetrieachse S eine asymmetrische Anordnung der einzelnen Schichten aufweist. Vorzugsweise beträgt die Schichtdicke d1 zwischen 0,2 mm und 3,0 mm, wohingegen die Schichtdicke d2 zwischen 0,1 mm und 2,0 mm beträgt. Die Dicke der ersten Verbindungsschicht 40 und/oder der zweiten Verbindungsschicht 41 beträgt beispielsweise zwischen 1 µm und 50 µm. Die Schichtdicke d3 kann zwischen 0,2 mm und 3,0 mm betragen.

In Fig. 2b wird hingegen ein nicht erfindungsgemäßer symmetrischer Aufbau bzw. eine nicht erfindungsgemäße symmetrische Anordnung der einzelnen Schichten 20, 25, 26, 30, 35 und Verbindungsschichten 40, 41, 42, 43 dargestellt. Zu erkennen ist, dass eine herzustellende Wärmespreizplatte 10 auch zwei Schichten aus dem zweiten dehnungsarmen Material M2 aufweisen kann. Hierbei handelt es sich um die zweite Schicht 30 sowie die vierte Schicht 35. Oberhalb und unterhalb der zweiten Schicht 30 sowie der vierten Schicht 35 ist jeweils eine Schicht aus einem ersten Material M1, nämlich die erste Schicht 20, die dritte Schicht 25 sowie die fünfte Schicht 26 ausgebildet. Die einzelnen Schichten, die aus dem ersten Material M1 bestehen, nämlich die Schichten 20, 25 und 26 sind mit den Schichten, die aus dem zweiten, dehnungsarmen Material M2 bestehen, nämlich der zweiten Schicht 30 und der vierten Schicht 35, mittels Verbindungsschichten 40, 41, 42 und 43 verbunden. Die Verbindungsschichten 40, 41, 42 und 43 weisen vorzugsweise das gleiche Verbindungsmaterial VM auf. Vorzugsweise handelt es sich hierbei um ein Sintermaterial, insbesondere eine Sinterpaste, die beispielsweise Silber und/oder Silberoxid und/oder Silberkarbonat aufweist.

Die angedeutete Symmetrieachse S zeigt, dass in der Ausführungsform gemäß Fig. 2b eine nicht erfindungsgemäße symmetrische Anordnung der Schichten 20, 25, 26, 30, 35 sowie der Verbindungsschichten 40 bis 43 vorliegt. Mit Hilfe einer Wärmespreizplatte 10, die in Fig. 2b dargestellt ist, kann eine Erhöhung der Dehnungsreduktion der Randschichten 20 und 26, die vorzugsweise aus Kupfer bestehen, erreicht werden. Dies wird mit Hilfe von zwei voneinander beabstandete Schichten 30 und 35, die aus einem dehnungsarmen Material, insbesondere Molybdän, bestehen, bewirkt.

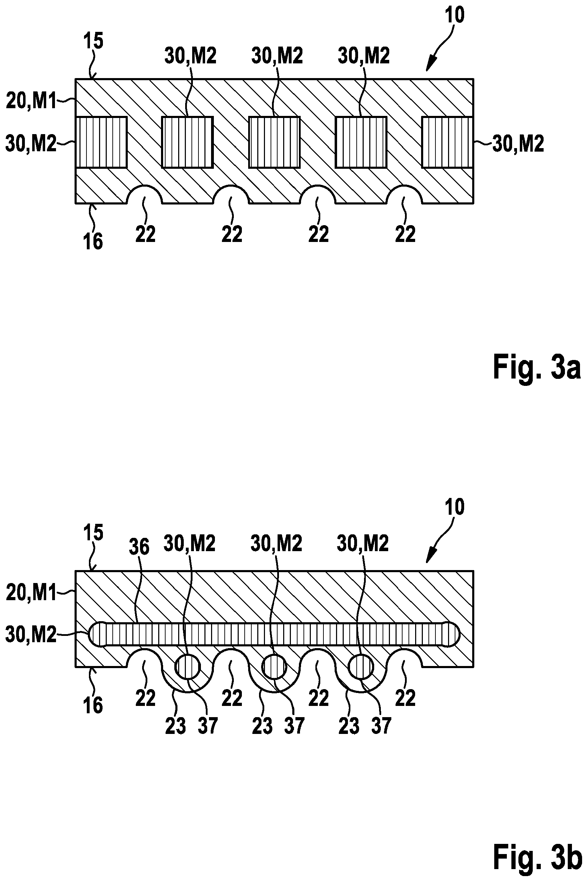

In Fig. 3a ist eine weitere Ausführungsform hinsichtlich einer Wärmespreizplatte 10 dargestellt. Hierbei ist die zweite Schicht 30 gitterartig ausgebildet. Das Gitter wäre bei einer entsprechenden Draufsicht auf die erste Seite 15 der ersten Schicht 20 sichtbar. Die zweite Schicht 30 ist in die erste Schicht 20 aus dem ersten Material M1 eingebettet. Auf der der ersten Seite 15 gegenüberliegenden Seite 16 der Wärmespreizplatte 10 sind halbrunde Ausnehmungen 22 eingebracht.

Gemäß der in Fig. 3b dargestellten Ausführungsform hinsichtlich einer Wärmespreizplatte 10 ist es ebenfalls vorgesehen, dass die zweite Schicht 30 in die erste Schicht 20 eingebettet ist. Auf der, der ersten Seite 15 der Wärmespreizplatte 10 gegenüberliegenden Seite 16 sind sowohl Ausnehmungen 22 als auch Auswölbungen 23 ausgebildet. Die zweite Schicht 30 ist aus einem oberen Abschnitt 36 und einem unteren Abschnitt 37 gebildet. Der untere Abschnitt 37 ist dabei drahtartig ausgebildet. Zu erkennen sind Querschnitte der Drähte. Die Drähte des unteren Abschnittes 37 sind dabei in den Auswölbungen 23 positioniert. Der obere Abschnitt 36 ist hingegen plattenartig ausgebildet, weist jedoch eine geringere Breite als die erste Schicht 20 auf.

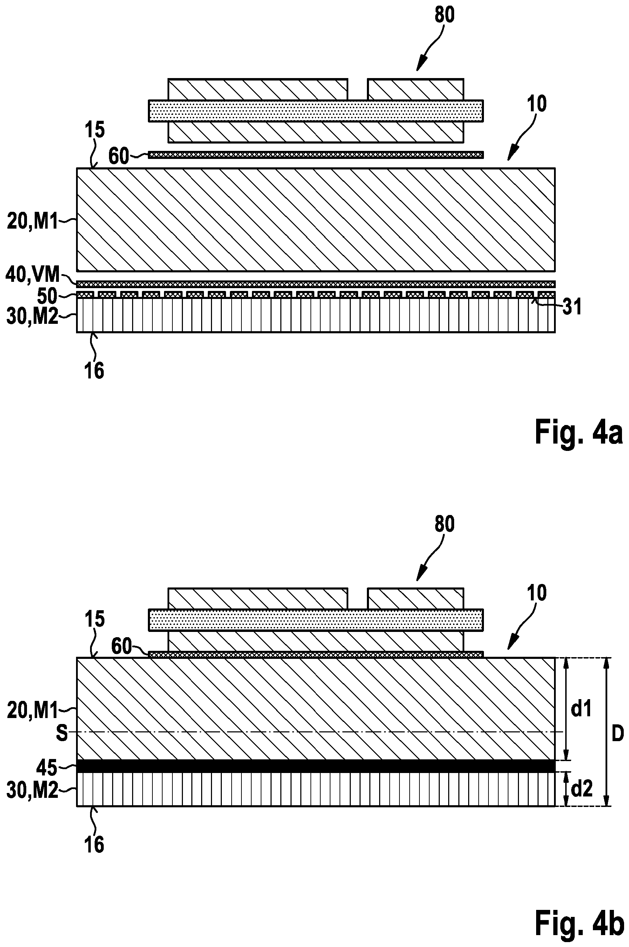

In Fig. 4a sind die einzelnen Schichten bzw. Bauteile eines herzustellenden Halbleitermoduls dargestellt. Die Wärmespreizplatte 10 wird demnach aus einer ersten Schicht 20 aus einem ersten Material M1 und einer zweiten Schicht 30 aus einem zweiten Material M2 gebildet. Zwischen der ersten Schicht 20 und der zweiten Schicht 30 ist eine Verbindungsschicht 40 ausgebildet. Bei dieser Verbindungsschicht handelt es sich vorzugsweise um eine Sinterschicht, die ein Verbindungsmaterial VM, nämlich Silber aufweist.

Auf der ersten Seite 31 der zweiten Schicht 30 ist eine haftverbessernde Schicht 50 aufgebracht. Bei der ersten Seite 31 der zweiten Schicht 30 handelt es sich um die der ersten Schicht 20 zugewandte Seite der zweiten Schicht 30. Die haftverbessernde Schicht 50 ist vorzugsweise galvanisch auf die zweite Schicht 30 aufgebracht. Bei der haftverbessernden Schicht 50 handelt es sich beispielsweise um eine Nickel-Silber-Schicht. Mit Hilfe der haftverbessernden Schicht 50 kann die Haftung zwischen der zweiten Schicht 30 und der Verbindungsschicht 40 verbessert werden. Im zusammengefügten Zustand (siehe Fig. 4b) liegt eine kombinierte Verbindungsschicht 45 vor. Mit Hilfe eines Niedertemperatursinterverfahrens werden die Verbindungsschicht 40 und die haftverbessernde Schicht 50 miteinander verpresst, so dass die kombinierte Verbindungsschicht 45 gebildet wird.

Mit Hilfe der in Fig. 4b angedeuteten Symmetrieachse S ist zu erkennen, dass die Wärmespreizplatte 10 einen asymmetrischen Aufbau hat. Bezüglich der Symmetrieachse S gelten die vorhergehenden Erklärungen. Der asymmetrische Aufbau wird durch unterschiedliche Schichtdicken der ersten Schicht 20 und der zweiten Schicht 30 erreicht. Die Schichtdicke d1 der ersten Schicht 20 ist größer als die Schichtdicke d2 der zweiten Schicht 30.

Bei dem Schaltungsträger 80 handelt es sich beispielsweise um ein sogenanntes DCB-Substrat. Dieses kann als Substratplatte aus Aluminiumoxid und/oder Aluminiumnitrid und/oder Siliziumnitrid und/oder Zirkoniumoxid verstärktes Aluminiumoxid ausgebildet sein.

Zur Verbindung des Schaltungsträgers 80 mit der Wärmespreizplatte 10 ist eine Kontaktierungsschicht 60 vorgesehen. Bei dieser Kontaktierungsschicht 60 kann es sich beispielsweise um eine Sinterpaste handeln. Es ist auch denkbar, dass es sich bei der Kontaktierungsschicht 60 um eine Klebeschicht oder um eine Lotschicht handelt. Der Schaltungsträger 80 wird mit Hilfe der Kontaktierungsschicht 60 auf die dem Schaltungsträger 80 zugewandte Seite 15 der Wärmespreizplatte 10 aufgebracht. Bei der mit dem Schaltungsträger 80 zu verbindenden Oberfläche 15 der Wärmespreizplatte 10 handelt es sich um die erste Seite 15 der ersten Schicht 20, wobei die erste Seite 15 der ersten Schicht 20 von der zweiten Schicht 30 abgewandt ausgebildet ist.

Zum Verbinden des Schaltungsträgers 80 mit der Wärmespreizplatte 10 wird die Anordnung mit einer Montagetemperatur von 150 °C - 300 °C beaufschlagt, wobei diese Montagetemperatur im Wesentlichen der Verbindungstemperatur bei der Verbindung der Schichten 20 und 30 der Wärmespreizplatte 10 entspricht. Es ist möglich, dass sowohl die Schichten 20 und 30 als auch der Schaltungsträger 80 in einem einzigen Schritt, d.h. gleichzeitig, miteinander verbunden werden.

Bei der in den Fig. 4a und 4b dargestellten Ausführungsform der Erfindung handelt es sich um den minimalst möglichen thermischen Stapel hinsichtlich einer Wärmespreizplatte 10, die mit einem Schaltungsträger 80 verbunden werden kann.

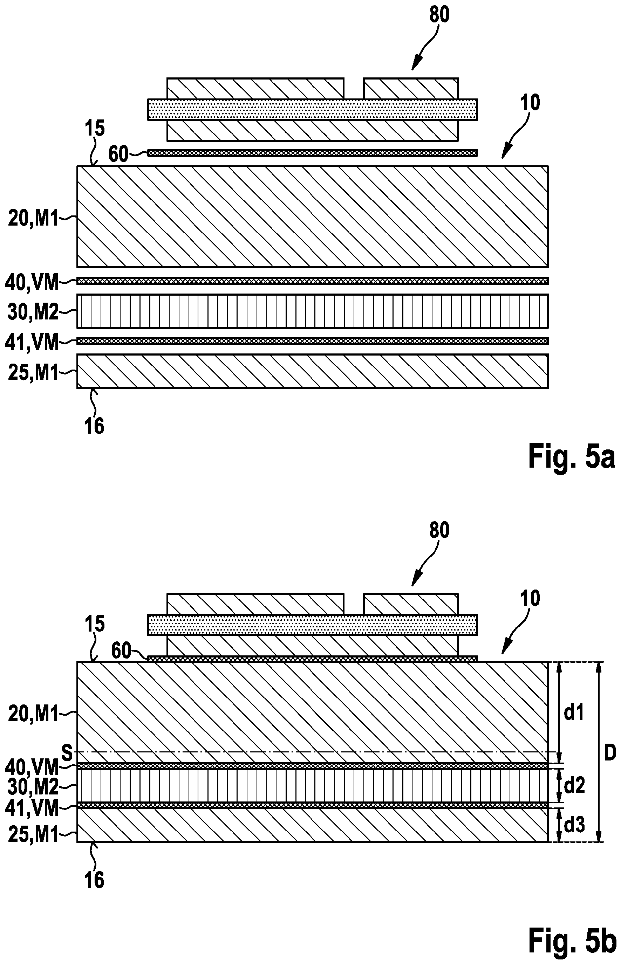

In Fig. 5a und 5b wird ebenfalls ein asymmetrischer Aufbau einer Wärmespreizplatte 10 dargestellt. Im Unterschied zu den Ausführungsformen der Fig. 4a und 4b besteht die Wärmespreizplatte 10 aus einer ersten Schicht 20, einer zweiten Schicht 30 und einer dritten Schicht 25. Die erste Schicht 20 und die dritte Schicht 25 weisen ein erstes Material M1 auf. Bei dem Material handelt es sich vorzugsweise um Kupfer. Zwischen diesen beiden Schichten 20 und 25, die unterschiedliche Schichtdicken d1 und d3 aufweisen, ist eine zweite Schicht 30 aus dem zweiten Material M2 ausgebildet. Das zweite Material M2 besteht aus einem dehnungsärmeren Material bzw. der Ausdehnungskoeffizient des zweiten Materials M2 ist geringer als der Ausdehnungskoeffizient des ersten Materials M1. Auf der asymmetrischen Wärmespreizplatte 10 ist wiederum ein Schaltungsträger 80 ausgebildet und kann somit zusammen mit einem aufzubringenden Halbleiterbaustein 90 (nicht dargestellt) ein Halbleitermodul 100 bilden.

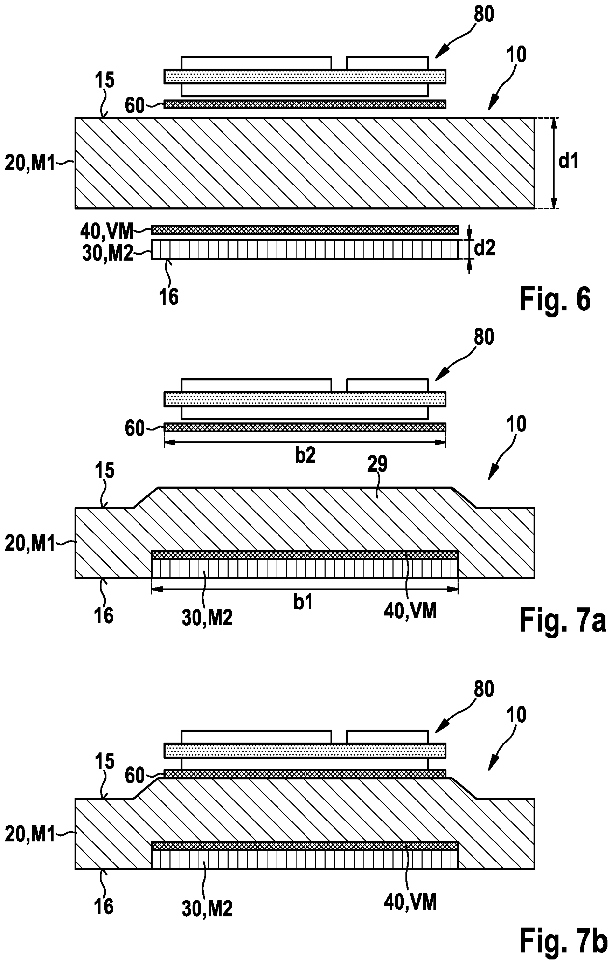

Auch die in Fig. 6 dargestellte Ausführungsform hinsichtlich eines herzustellenden Halbleitermodules beruht auf einer asymmetrischen Wärmespreizplatte 10. Eine erste Schicht 20 aus erstem Material M1, beispielsweise Kupfer, wird mit einer zweiten Schicht 30 aus zweitem Material M2 mit dehnungsarmem Material verbunden. Hierzu ist zwischen den beiden Schichten 20 und 30 eine Verbindungsschicht 40 ausgebildet. Die Schichtdicke d1 der ersten Schicht 20 beträgt dabei das 6Fache der Schichtdicke d2 der zweiten Schicht 30. Auf der ersten Seite 15 der ersten Schicht 20 kann wiederum mit Hilfe einer Kontaktierungsschicht 60 ein Schaltungsträger 80 aufgebracht werden.

Die zweite Schicht 30 weist außerdem eine geringere Breite als die erste Schicht 20 auf. Die Breite der zweiten Schicht 30 entspricht in etwa der Breite der Kontaktierungsschicht 60.

Im Ausführungsbeispiel gemäß Fig. 7a und 7b wird eine weitere Anordnung, bestehend aus einer Wärmespreizplatte 10 und einem Schaltungsträger 80, dargestellt. In Fig. 7a sind dabei die beiden Bauteile im unverbundenen Zustand dargestellt.

Die Wärmespreizplatte 10 weist eine erste Schicht 20 sowie eine zweite Schicht 30 auf. Die zweite Schicht 30 ist in die erste Schicht 20, die aus dem ersten Material M1 besteht, eingebettet. In eine Ausformung der ersten Schicht 20 ist somit die geometrisch kleinere zweite Schicht 30 eingebracht und mittels einer Verbindungsschicht 40 verbunden. Die Breite b1 der zweiten Schicht 30 entspricht im Wesentlichen der Breite b2 der Kontaktierungsschicht 60. Der Schaltungsträger 80 ist oberhalb der zweiten Schicht 30 derart angeordnet, dass der Schaltungsträger 80, insbesondere die Kontaktierungsschicht 60, deckungsgleich zur zweiten Schicht 30 ausgebildet ist.

Die Wärmespreizplatte 10 weist außerdem ein erhöhtes Plateau 29 auf. Auf diesem Plateau 29 kann der Schaltungsträger 80 auf der obersten Seite 15 angebracht werden. Das erhöhte Plateau 29 kann als Montagehilfe dienen. Außerdem trägt dieses Plateau 29 zu einer asymmetrischen Anordnung der einzelnen Schichten der Wärmespreizplatte 10 bei. Das Plateau 29 kann beispielsweise durch Verpressen der in Fig. 6 dargestellten Schichten 20 und 30 hergestellt werden.

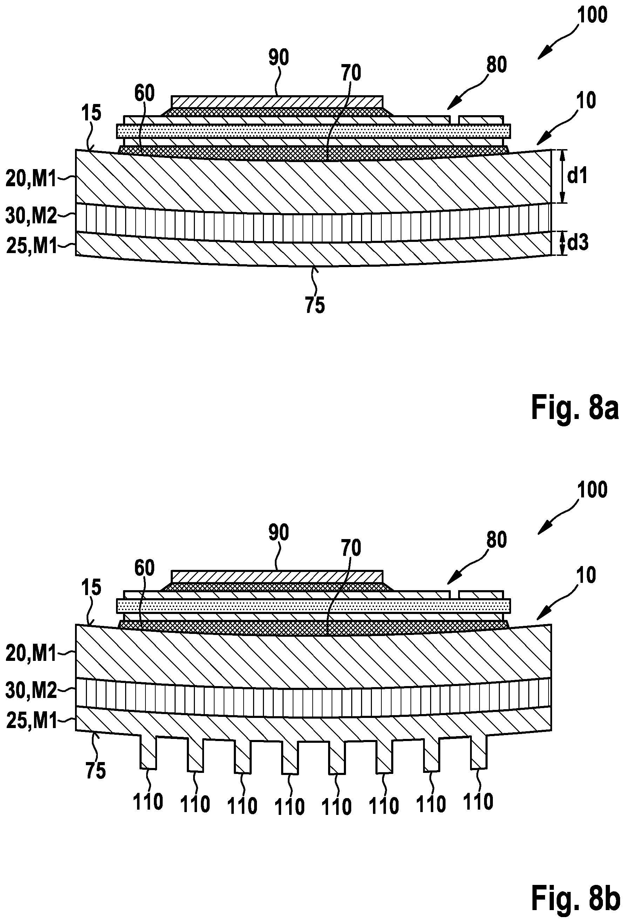

In Fig. 8a ist ein Halbleitermodul 100 dargestellt, wobei die Wärmespreizplatte 10 eine konkave Form aufweist. Die konkave Form der Wärmespreizplatte 10 wird aufgrund des asymmetrischen Aufbaus der Wärmespreizplatte 10 hervorgerufen. Die Schichtdicke d3 der dritten Schicht 25 ist geringer als die Schichtdicke d1 der ersten Schicht 20, so dass die Wärmespreizplatte 10 insgesamt in Richtung der dritten Schicht 25 gebogen wird. Ein Schaltungsträger 80, auf dem ein Halbleiterbaustein 90 angebracht ist, ist mit der ersten Seite 15 der ersten Schicht 20 der Wärmespreizplatte 10, also der obersten Seite 15 der Wärmespreizplatte 10 verbunden. Der Schaltungsträger 80 ist derart mit der Wärmespreizplatte 10 verbunden, dass die aufgrund der konkaven Form der Wärmespreizplatte 10 entstehende Einbuchtung 70 die mittige Position des Schaltungsträgers 80 markiert.

In Fig. 8b ist ein weiteres Halbleitermodul 100 dargestellt. Die Wärmespreizplatte 10 weist in dieser Ausführungsform Kühlfinnen 110 auf. Ansonsten gleicht der Aufbau des Halbleitermoduls 100 der Fig. 8b dem Aufbau der Ausführungsform gemäß Fig. 8a.

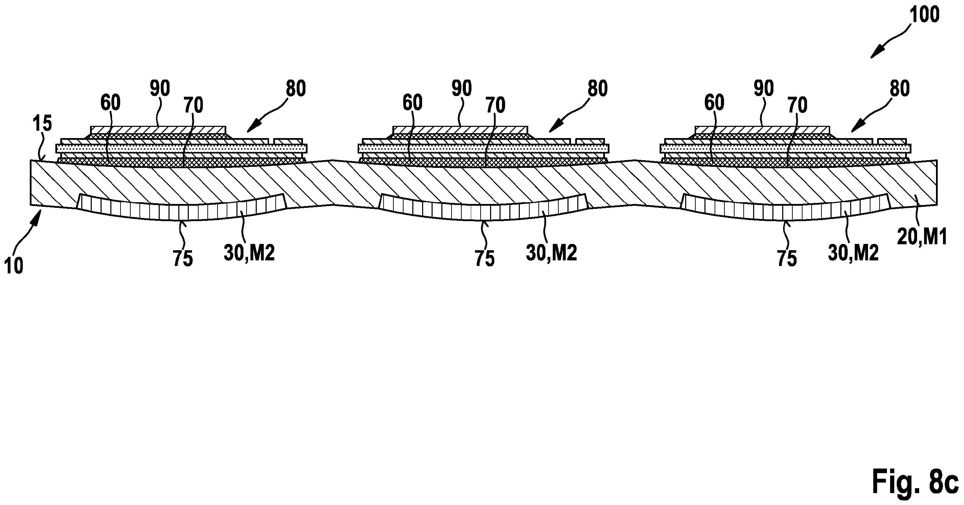

In Fig. 8c wird dargestellt, dass eine Wärmespreizplatte 10 mehrere konkave Ausformungen aufweisen kann, so dass im dargestellten Beispiel drei Einbuchtungen 70 ausgebildet sind, wobei die drei Schaltungsträger 80 jeweils mittig zur Einbuchtung 70 auf der ersten Seite 15 der ersten Schicht 20 angeordnet sind. Die konkaven Ausformungen bzw. balligen Seiten 75 der Wärmespreizplatte 10 werden dadurch gebildet, dass in die erste Schicht 20, die aus einem ersten Material M1 besteht, drei Abschnitte von zweiten Schichten 30 eingebettet sind. Die zweiten Schichten 30 sind dabei derart angeordnet, dass die balligen Seiten 75 bzw. die Einbuchtungen 70 ober- bzw. unterhalb der Position der jeweils zweiten Schicht 30 ausgebildet sind.

Es wäre möglich, die Anordnung der Fig. 8c zu zerteilen, so dass drei voneinander unabhängige Halbleitermodule 100 gebildet werden.

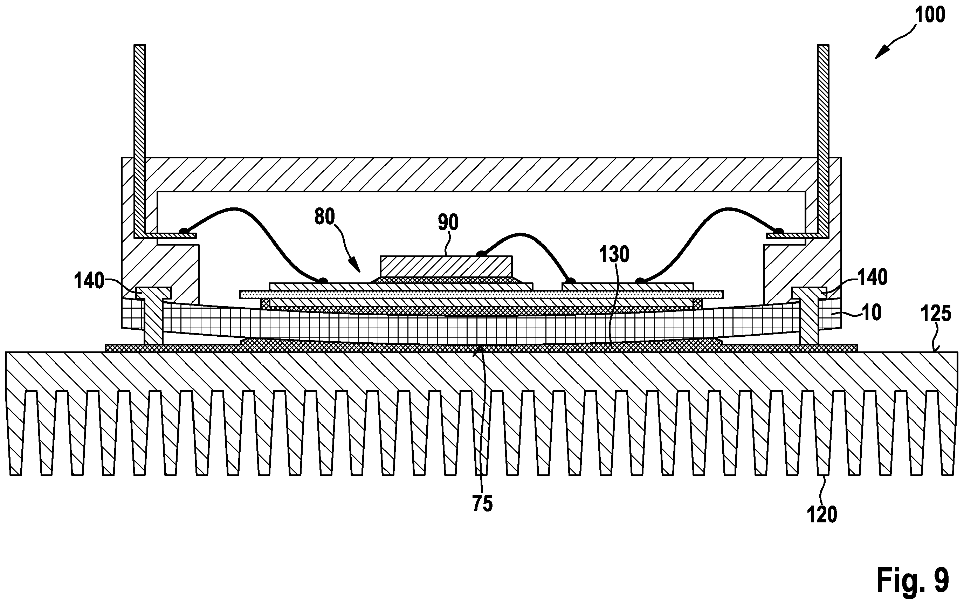

In Fig. 9 ist ein Halbleitermodul 100 dargestellt, das eine konkav geformte Wärmespreizplatte 10, einen Schaltungsträger 80, einen Kühler 120 sowie einen auf dem Schaltungsträger 80 befindlichen und mit diesem verbundenen Halbleiterbaustein 90 umfasst. Zwischen der Wärmespreizplatte 10 und dem Kühler 120 ist eine Wärmeleitpaste 130 ausgebildet. Es handelt sich vorzugsweise um eine plastische Wärmeleitpaste 130, die möglichst dünn und frei von Lufteinschlüssen zwischen der Wärmespreizplatte 10 und dem Kühler 120 appliziert ist. Die ballige Seite 75 bzw. die der Einbuchtung 70 gegenüberliegende Seite der Wärmespreizplatte 10 wird auf die Oberfläche 125 des Kühlers 120 montiert.

Mit Hilfe von Schrauben 140, die als Spannvorrichtung wirken, wird die Wärmeleitplatte 10 auf die Oberfläche 125 des Kühlers 120 gepresst. Mit steigendem Montagedruck wird die Wärmeleitpaste 130 von innen nach außen gedrückt und füllt auf diese Art und Weise den Spalt zwischen der Wärmespreizplatte 10 und der Oberfläche 125 des Kühlers 120.

In Fig. 9 ist lediglich ein teilmontierter Zustand dargestellt. Im vollständig montierten Zustand liegt die Wärmespreizplatte 10 vorzugsweise vollständig auf der Oberfläche 125 des Kühlers 120 auf. Eine raue Oberfläche 125 oder Konturfehler der Wärmespreizplatte 10 und des Kühlers 120 werden durch die Wärmeleitpaste 130 ausgeglichen. Bei dem abgebildeten Kühler 120 handelt es sich um einen sogenannten Luftkühler.

### Bezugszeichenliste

- 10: Wärmespreizplatte
- 15: erste Seite erste Schicht
- 16: Seite Wärmespreizplatte
- 20: erste Schicht
- 22: Ausnehmung
- 23: Auswölbung
- 25: dritte Schicht
- 26: fünfte Schicht
- 29: Plateau
- 30: zweite Schicht
- 31: erste Seite zweite Schicht
- 35: vierte Schicht
- 36: oberer Abschnitt
- 37: unterer Abschnitt
- 40: erste Verbindungsschicht
- 41: zweite Verbindungsschicht
- 42: dritte Verbindungsschicht
- 43: vierte Verbindungsschicht
- 45: kombinierte Verbindungsschicht
- 50: haftverbessernde Schicht
- 60: Kontaktierungsschicht
- 70: Einbuchtung
- 75: ballige Seite
- 80: Schaltungsträger
- 90: Halbleiterbaustein
- 100: Halbleitermodul
- 110: Kühlfinne
- 120: Kühler
- 125: Oberfläche Kühler
- 130: Wärmeleitpaste
- 140: Schraube
- b1: Breite zweite Schicht
- b2: Breite Kontaktierungsschicht
- d1: Schichtdicke erste Schicht
- d2: Schichtdicke zweite Schicht
- d3: Schichtdicke dritte Schicht
- d4: Schichtdicke vierte Schicht
- d5: Schichtdicke fünfte Schicht
- D: Gesamtdicke Wärmespreizplatte
- M1: erstes Material
- M2: zweites Material
- S: Symmetrieachse
- VM: Verbindungsmaterial
- 70: Einbuchtung
- 75: ballige Seite
- 80: Schaltungsträger
- 90: Halbleiterbaustein
- 100: Halbleitermodul
- 110: Kühlfinne
- 120: Kühler
- 125: Oberfläche Kühler
- 130: Wärmeleitpaste
- 140: Schraube
- b1: Breite zweite Schicht
- b2: Breite Kontaktierungsschicht
- d1: Schichtdicke erste Schicht
- d2: Schichtdicke zweite Schicht
- d3: Schichtdicke dritte Schicht
- d4: Schichtdicke vierte Schicht
- d5: Schichtdicke fünfte Schicht
- D: Gesamtdicke Wärmespreizplatte
- M1: erstes Material
- M2: zweites Material
- S: Symmetrieachse
- VM: Verbindungsmaterial

## Patentansprüche

1. Wärmespreizplatte (10) für einen Schaltungsträger (80), umfassend:
- mindestens eine erste Schicht (20) aus einem ersten Material (M1) mit einem ersten Ausdehnungskoeffizient,
- mindestens eine zweite Schicht (30) aus einem zweiten, dehnungsarmen Material (M2) mit einem zweiten Ausdehnungskoeffizient, der kleiner als der erste Ausdehnungskoeffizient ist,
- wobei zwischen der ersten Schicht (20) und der zweiten Schicht (30) mindestens eine erste Verbindungsschicht (40), die Diffusionsmetall, insbesondere Silber (Ag) und/oder eine Silberlegierung und/oder Gold (Au) und/oder eine Goldlegierung und/oder Kupfer (Cu) und/oder eine Kupferlegierung, umfasst, ausgebildet ist,
**gekennzeichnet durch**
eine asymmetrische Anordnung der ersten Schicht (20), der zweiten Schicht (30) und der Verbindungsschicht (40), derart, dass eine konvex oder konkav geformte Wärmespreizplatte gebildet ist.

2. Wärmespreizplatte (10) nach Anspruch 1,
**dadurch gekennzeichnet, dass**
die mindestens erste Verbindungsschicht (40) als Grenzschicht der ersten Schicht (20) und/oder der zweiten Schicht (30) ausgebildet ist.

3. Wärmespreizplatte (10) nach Anspruch 1 oder 2,
**dadurch gekennzeichnet, dass**
das erste Material Metall (M1), insbesondere Kupfer (Cu) oder eine Kupferlegierung, aufweist und/oder das zweite Material (M2) eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), besonders bevorzugt Molybdän (Mo), aufweist.

4. Wärmespreizplatte (10) nach einem der Ansprüche 1 bis 3,
**gekennzeichnet durch**
mindestens eine dritte Schicht (25) aus einem/dem ersten Material (M1), die mittels einer zweiten Verbindungsschicht (41) aus einem/dem Verbindungsmaterial (VM) mit der zweiten Schicht (30) aus einem/dem zweiten, dehnungsarmen Material (M2) verbunden ist.

5. Wärmespreizplatte (10) nach Anspruch 4,
**gekennzeichnet durch**
mindestens eine vierte Schicht (35) aus einem/dem zweiten Material (M2), die mittels einer dritten Verbindungsschicht (42) aus einem/dem Verbindungsmaterial (VM) mit der dritten Schicht (25) aus einem/dem ersten Material (M1) verbunden ist.

6. Wärmespreizplatte (10) nach einem der Ansprüche 1 bis 5,
**gekennzeichnet durch**
eine asymmetrische Anordnung der einzelnen Schichten (20, 25, 26, 30, 35) und Verbindungsschicht(en) (40, 41, 42, 43), derart, dass eine konvex oder konkav geformte Wärmespreizplatte (10) gebildet ist.

7. Wärmespreizplatte () nach einem der Ansprüche 1 bis 6,
**dadurch gekennzeichnet, dass**
die zweite Schicht (30) und/oder die vierte Schicht (35) in einer Schicht (20, 25, 26) aus dem ersten Material (M1) eingebettet ist.

8. Wärmespreizplatte (10) nach einem der Ansprüche 1 bis 7,
**dadurch gekennzeichnet, dass**
die zweite Schicht (30) und/oder die vierte Schicht (35) rahmenartig und/oder gitterartig und/oder drahtartig ausgebildet ist.

9. Verfahren zur Herstellung eines Halbleitermoduls (100),
umfassend eine Wärmespreizplatte (10) nach einem der Ansprüche 1 bis 8 und mindestens einen Schaltungsträger (80), der mindestens einen Halbleiterbaustein (90) trägt,
**dadurch gekennzeichnet, dass**
der Schaltungsträger (80) mittels einer Kontaktierungsschicht (60) mit der Wärmespreizplatte (10) bei einer Montagetemperatur von 150 °C - 300 °C verbunden wird, wobei die Montagetemperatur im Wesentlichen der Verbindungstemperatur bei der Verbindung von/der Schichten (20, 25, 26, 30, 35, 40, 41, 42, 43) der Wärmespreizplatte (10) entspricht.

10. Verfahren nach Anspruch 9,
**dadurch gekennzeichnet, dass**
die Verbindung der Schichten (20, 25, 26, 30, 35, 40, 41, 42, 43) der Wärmespreizplatte (10) und die Verbindung des Schaltungsträgers (80) mit der Wärmespreizplatte (10) gleichzeitig erfolgt.

11. Verfahren nach Anspruch 9 oder 10,
**dadurch gekennzeichnet, dass**
die Montagetemperatur 200 °C - 280 °C, insbesondere 220 °C - 270 °C, insbesondere 240 °C - 260 °C, insbesondere 250 °C, beträgt.

12. Halbleitermodul (100), hergestellt nach einem der Ansprüche 9 bis 11, umfassend
eine Wärmespreizplatte (10) nach einem der Ansprüche 1 bis 8 und mindestens einen Schaltungsträger (80), der mindestens einen Halbleiterbaustein (90) trägt.

13. Halbleitermodul (100) nach Anspruch 12,
**dadurch gekennzeichnet, dass**
der Schaltungsträger (80) als DCB-Substrat, insbesondere als Substratplatte aus Aluminiumoxid (Al₂O₃) und/oder Aluminiumnitrid (AIN) und/oder Siliziumnitrid (Si₃N₄) und/oder Zirkoniumoxid verstärktes Aluminiumoxid (ZTA zirconia toughened alumina), ausgebildet ist.

14. Halbleitermodul (100) nach Anspruch 12 oder 13,
**dadurch gekennzeichnet, dass**
die Wärmespreizplatte (10) mit einem Kühler (120) verbunden ist, wobei vorzugsweise zwischen der Wärmespreizplatte (80) und dem Kühler (120) eine Wärmeleitpaste (130) ausgebildet ist.

## Claims

1. Heat spreading plate (10) for a circuit carrier (80) comprising:
- at least one first layer (20) made of a first material (M1) with a first coefficient of expansion,
- at least one second layer (30) made of a second, low-expansion material (M2) with a second coefficient of expansion which is smaller than the first coefficient of expansion,
- wherein arranged between the first layer (20) and the second layer (30) is at least one connection layer (40) comprising diffusion metal, more particularly silver (Ag) and/or a silver alloy and/or gold (Au) and/or a gold alloy and/or copper (Cu) and/or a copper alloy,
**characterised by**
an asymmetrical arrangement of the first layer (20), the second layer (30) and the connection layer (40) in such a way that a convex or concave-shaped heat spreading plate is formed.

2. Heat spreading plate (10) according to claim 1
**characterised in that**
the at least one connection layer (40) is formed as a boundary layer of the first layer (20) and/or of the second layer (30).

3. Heat spreading plate (10) according to claim 1 or 2
**characterised in that** the
first material (M1) comprises metal, in particular copper (Cu) or a copper alloy, and/or the second material (M2) comprises a nickel alloy, in particular invar (Fe₆₅Ni₃₅) or invar 36 (Fe₆₄Ni₃₆) or covar (Fe₅₄Ni₂₉Co₁₇), and/or tungsten (W) and/or an iron-nickel-cobalt alloy (FeNiCo alloy), particularly preferably molybdenum (Mo).

4. Heat spreading plate (10) according to any one of claims 1 to 3
**characterised by**
at least one third layer (25) made of a/the first material (M1) which is connected by means of a second connection layer (41) made of a/the connection material (VM) to the second layer (30) made of a/the second, low-expansion material (M2).

5. Heat spreading plate (10) according to claim 4
**characterised by**
at least one fourth layer (35) made of a/the second material (M2), which is connected by means of a third connection layer (42) made of a/the connection material (VM) to the third layer (25) made of a/the first material (M1).

6. Heat spreading plate (10) according to any one of claims 1 to 5
**characterised by**
an asymmetrical arrangement of the individual layers (20, 25, 26, 30, 35) and connection layer(s) (40, 41, 42, 43) such that a convex or concave-shaped heat spreading plate (10) is formed.

7. Heat spreading plate (10) according to any one of claims 1 to 6
**characterised in that**
the second layer (30) and/or the fourth layer (35) is/are embedded in a layer (20, 25, 26) made of the first material (M1).

8. Heat spreading plate (10) according to any one claims 1 to 7
**characterised in that**
the second layer (30) and/or the fourth layer (35) is configured in a frame-like and/or grid-like and/or wire-like manner.

9. Method of producing a semiconductor module (100) comprising a heat spreading plate (10) according to any one of claims 1 to 8 and at least one circuit carrier (80) which bears at least one semiconductor component (90),
**characterised in that**
the circuit carrier (80) is connected by means of a contacting layer (60) to the heat spreading plate (10) at an assembly temperature of 150 °C - 300 °C, wherein the assembly temperature essentially corresponds to the connection temperature at the time of connection of layers/of the layers (20, 22, 26, 30, 35, 40, 41, 42, 43) of the heat spreading plate (10).

10. Method according to claim 9
**characterised in that**
the connection of the layers (20, 25, 26, 30, 35, 40, 41, 42, 43) of the heat spreading plate (10) and the connection of the circuit carrier (80) to the heat spreading plate (10) take place at the same time.

11. Method according to claim 9 or 10,
**characterised in that**
the assembly temperature is 200 °C - 280 °C, in particular 220 °C - 270 °C, in particular 240 °C - 260 °C, in particular 250 °C.

12. Semiconductor module (100) produced in accordance with any one of claims 9 to 11
comprising
a heat spreading plate (10) according to any one of claims 1 to 8 and at least one circuit carrier (80) bearing at least one semiconductor component (90).

13. Semiconductor module (100) according to claim 12
**characterised in that**
the circuit carrier (80) is configured as a DCB substrate, more particularly as a substrate plate made of aluminium oxide (Al₂O₃) and/or aluminium nitride (AIN) and/or silicon nitride (Si₃N₄) and/or zirconium oxide-reinforced aluminium oxide (ZTA zirconia toughened alumina).

14. Semiconductor module (100) according to claim 12 or 13
**characterised in that**
the heat spreading plate (10) is connected to a cooler (120), wherein preferably a heat conducting paste (130) is arranged between the heat spreading plate (80) and the cooler (120).

## Revendications

1. Plaque de dissipation thermique (10) pour un support de circuit (80), comprenant :
- au moins une première couche (20) dans un premier matériau (M1) avec un premier coefficient d'expansion ,
- au moins une deuxième couche (30) dans un deuxième matériau à faible expansion (M2) avec un deuxième coefficient d'expansion , qui est plus faible que le premier coefficient d'expansion ,
- sachant qu'entre la première couche (20) et a deuxième couche (30) est constituée au moins une première couche de liaison (40), qui comprend un métal de diffusion, en particulier de l'argent (Ag) et/ou un alliage d'argent et/ou de l'or (Au) et/ou un alliage d'or et/ou du cuivre (Cu) et/ou un alliage de cuivre,
**caractérisé par**
une disposition asymétrique de la première couche (20), de la deuxième couche (30) et de la couche de liaison (40) de telle manière qu'une plaque de dissipation thermique de forme convexe ou concave est formée.

2. Plaque de dissipation thermique (10) selon la revendication 1,
**caractérisée en ce qu'**
au moins la première couche de liaison (40) est constituée comme couche limite de la première couche (20) et/ou de la deuxième couche (30).

3. Plaque de dissipation thermique (10) selon la revendication 1 ou 2,
**caractérisée en ce que**
le premier matériau comporte du métal (M1), en particulier du cuivre (Cu) ou un alliage de cuivre et/ou le deuxième matériau (M2) comporte un alliage de cuivre, en particulier de l'Invar (Fe₆₅Ni₃₅) ou de l'Invar 36 (Fe₆₄Ni₃₅) ou du Kovar (Fe₅₄Ni₂₉Co₁₇) et/ou de tungstène (W) et/ou un alliage Fer-Nickel-Cobalt (alliage FeNiCo), en particulier de préférence du molybdène (Mo) .

4. Plaque de dissipation thermique (10) l'une quelconque des revendications 1 à 3,
**caractérisée par**
au moins une troisième couche (25) dans le/un premier matériau (M1), qui est reliée au moyen d'une deuxième couche de liaison (41) dans le/un matériau de liaison (VM) à la deuxième couche (30) dans le/un deuxième matériau (M2) à faible expansion.

5. Plaque de dissipation thermique (10) selon la revendication 4,
**caractérisée par**
au moins une quatrième couche (35) dans le/un deuxième matériau (M2), qui est reliée au moyen d'une troisième couche de liaison (42) dans le/un matériau de liaison (VM) à la troisième couche (25) dans le/un premier matériau (M1).

6. Plaque de dissipation thermique (10) selon l'une quelconque des revendications 1 à 5,
**caractérisée par**
une disposition asymétrique des couches individuelles (20, 25, 26, 30, 35) et des couches de liaison (40, 41, 42, 43) de telle manière qu'une plaque de dissipation thermique (10) de forme convexe ou concave est formée.

7. Plaque de dissipation thermique (10) selon l'une quelconque des revendications 1 à 6,
**caractérisée en ce que**
la deuxième couche (30) et/ou la quatrième couche (35) est encastrée dans une couche (20, 25, 26) du premier matériau (M1).

8. Plaque de dissipation thermique (10) selon l'une quelconque des revendications 1 à 7,
**caractérisée en ce que**
la deuxième couche (30) et/ou la quatrième couche (35) est constituée en forme de cadre et/ou en forme de grille et/ou en forme de fil.

9. Procédé de fabrication d'un module à semi-conducteurs (100),
comprenant une plaque de dissipation thermique (10) selon l'une quelconque des revendications 1 à 8 et au moins un support de circuit (80), qui, porte au moins un composant à semi-conducteurs (90),
**caractérisé en ce que**
le support de circuit (80) est relié au moyen d'une couche de contact (60) à la plaque de dissipation thermique (10) à une température de montage de 150° - 300 °C, sachant que la température de montage correspond pour l'essentiel à la température de liaison lors de la liaison des/de la couche(s) (20, 25, 26, 30, 35, 40, 41, 42, 43) de la plaque de dissipation thermique (10).

10. Procédé selon la revendication 9,
**caractérisé en ce que**
la liaison des couches (20, 25, 26, 30, 35, 40, 41, 42, 43) de la plaque de dissipation thermique (10) et la liaison du support de circuit (80) a lieu simultanément avec la plaque de dissipation thermique (10).

11. Procédé selon la revendication 9 ou 10,
**caractérisé en ce que**
la température de montage est de 200 °C - 280 °C, en particulier de 220 °C - 270 °C, en particulier de 240 °C - 260 °C, en particulier de 250 °C.

12. Module à semi-conducteurs (100) fabriqué selon l'une quelconque des revendications 9 à 11,
comprenant
une plaque de dissipation thermique (10) selon l'une quelconque des revendications 1 à 8 et au moins un support de circuit (80), qui porte au moins un composant à semi-conducteurs (90).

13. Module à semi-conducteurs (100) selon la revendication 12,
**caractérisé en ce que**
le support de circuit (80) est constitué sous la forme d'un substrat à liant de cuivre direct DCB, en particulier comme plaque de substrat en oxyde d'aluminium (Al₂O₃) et/ou nitrure d'aluminium (AlN) et/ou nitrure de silicium (Si₃N₄) et/ou oxyde de d'aluminium renforcé à l'oxyde de zirconium (ZTA zirconia toughened alumina).

14. Module à semi-conducteurs (100) selon la revendication 12 ou 13,
**caractérisé en ce que**
la plaque de dissipation thermique (10) est reliée à un refroidisseur (120), sachant de préférence qu'entre la plaque de dissipation thermique (80) et le refroidisseur (120) est constituée une pâte thermoconductrice (130).
